# EUROPEAN PATENT APPLICATION

(11) **EP 1 369 682 A2**
(43) Date of publication of application: **10.12.2003**
(21) Application number: 03447145.8
(22) Date of filing: 05.06.2003
(51) Int. Cl.: G01N 21/95, G01N 21/91, G01R 31/265, G01R 31/311, H01L 21/66

(54) **A method for wafer level detection of integrity of a layer**

(30) Priority: 07.06.2002 US 386965 P
(71) Applicant: INTERUNIVERSITAIR MICROELEKTRONICA CENTRUM VZW, 3001 Leuven (BE)
(72) Inventor: Holsteyns, Frank, 3290 Diest (BE); Iacopi, Francesca, 3001 Leuven (BE); Maex, Karen, 3020 Herent (BE)
(74) Representative: Bird, William Edward

(57) **Abstract**

The present invention relates to an optical method to perform the optical method for detecting the integrity of a material system. The method comprises optical inspection before and after a solvent absorption step. On the basis of whether or not a solvent is being absorbed, one can determine whether or not there are defects present in a layer which covers and has to protect an underlying layer deposited on a semiconductor substrate. The method may be used at the processing level, to determine whether a covering layer formed on a semiconductor substrate in the manufacturing of e.g. an electronic device has any defects or not, and hence if the device can be further processed or has to be taken out of the processing.

## Description

### Technical field of the invention

The present invention relates to a method and apparatus for the detection of the integrity of a material system. The material system can for example be a covering layer used on top of an underlying layer in semiconductor processing or packaging of a semiconductor device.

### Background of the invention

In semiconductor processing several layers may be deposited onto semiconductor substrates to form for example electronic devices. In some cases these layers, further referred to as underlying layers, have to be protected against all kinds of environmental influences, such as for example moisture. Therefore a protecting layer, further referred to as a covering layer, is deposited on top of an underlying layer so as to protect this underlying layer.

The semiconductor industry's need for an insulating material with a low dielectric constant (also called k-value) arises from the fact that chip speed is limited by the resistance and the dielectric constant of the metal line and the surrounding insulator. Higher chip speeds require new types of material. Preferably, such materials have dielectric constants of 2.0 or lower. The push for low-k dielectric materials is motivated by a desire to reduce capacitance, e.g. capacitance between interconnects in ultra large-scale integrated circuits. Reducing capacitance also minimises crosstalk between adjacent metal lines, an increasingly severe problem. Low-k dielectrics are applicable to a broad spectrum of applications sensitive to ever finer geometries, crosstalk and higher frequencies.

Materials (organic or inorganic) with a low relative permittivity can exhibit a constitutive porosity and/or a subtractive porosity. Constitutive porosity is typical for materials with a k-value in the order of 2.7. Subtractive porosity occurs in case materials with a k-value smaller than 2.7 are used. Materials with low relative permittivity can be very sensitive to the environment to which they are exposed, be it the air environment or the process environment or any environment to which the material is subjected, deliberately or unintentionally. These exposures can lead to problems such as unwanted process interactions, absorption of molecules, contamination during the processing steps, mobile ions drift diffusion. All these lead to degradation of electrical, physical, chemical and/or mechanical properties of the porous material layer, and can lead to an undesirable increase in dielectric constant of that layer.

The material layers do not necessarily need to be porous. In that case a solvent does not penetrate into the pores of the material, but for example makes the material swell and this way destroys it or deteriorates its properties.

To avoid a change in the k value due to absorption or adsorption of moisture, gases, liquids, or any other substances during or in between the different processing steps, porous layers can be encapsulated (sealed) by other layers, that is by so-called by covering layers. A covering layer has to be provided on any exposed surface of the low-k material layer. This covering layer can be obtained by deposition of a thin film onto any exposed surface of the low-k layer or by treating the porous material for pore sealing, i.e. e.g. plasma treatment, chemical treatment, deposition of self assembled monolayer, etch. Etching of vias or trenches can result in pore sealing. This is due to the plasma treatment and the chemical nature of the plasma. As such, etching as used in the context of the present invention is included in the plasma treatment and chemical treatment. The covering layer has to be as thin as possible in order to keep the overall dielectric constant as low as possible. If the covering layer is too thick, this will result in an increase of the dielectric constant. Porous materials are used because of their low dielectric value. In consequence of the covering layer being as thin as possible, it is possible that the covering layer is discontinuous and hence certain parts of the underlying layer are not completely covered by the covering layer. A discontinuity of the covering layer or the presence of defects in such layer can lead to the exposure of the underlying layer, e.g. low k dielectric layer, to the environment and therefore to degradation of electrical, physical, chemical and/or mechanical properties such underlying layer. Thick layers have a low defect rate but a poor performance, and thinner covering layers have a better performance but a higher defect rate.

In view of the above, it is important that covering layers are free from defects. Techniques that are able to monitor defects in the covering layer during processing are required. Preferably these techniques are non-destructive, in which case for example a further sealing layer can be provided on top of the defective sealing layer already present, after which the refurbished devices can be monitored for defects once again, and if allowable, they can be processed further. Alternatively, these techniques are destructive. In this case, these monitoring methods can be used to remove devices in which covering layers show defects from the processing line, whereas devices without defects in the covering layer can be processed further.

### Summary of the invention

It is an object of the present invention to provide a method and apparatus to detect defects in the covering layer of a device.

The present invention provides a non-destructive or destructive method for localising and optionally quantifying defects in a covering layer in order to perform quality control on the level of process acceptance, for example of wafer acceptance. The present invention also provides a method and apparatus for determining the minimal sealing thickness of a certain barrier that can be used on a given dielectric material layer.

The present invention provides a method for determining integrity of a covering layer on a semiconductor substrate, said method comprising:
providing the semiconductor substrate comprising the covering layer, said covering layer being at least partially exposed,
subjecting at least a part of said covering layer to a first substance,
subjecting at least a part of said covering layer to a light beam,
detecting an optical property of the covering layer,
indicating the integrity of said covering layer by determining if said optical property differs from a first threshold value, the optical property indicating a level of penetration of the first substance through the covering layer.

Detecting an optical property may comprise detecting an amount of light scattered and rejecting light directly reflected by the covering layer, and indicating the integrity of said covering layer may comprise determining if said amount of scattered light differs from a first threshold value, the amount of scattered light indicating a level of penetration of the first substance through the covering layer. Alternatively, detecting an optical property may comprise detecting an amount of light transmitted or absorbed by the covering layer, and indicating the integrity of said covering layer may comprise determining if said amount of transmitted or absorbed light differs from a first threshold value, the amount of transmitted or absorbed light indicating a level of penetration of the first substance through the covering layer.

Said covering layer may have holes, and said first substance may be able to interact with said semiconductor substrate or an underlying layer between said semiconductor substrate and said covering layer.

Said first substance may be a liquid, a vapour or a gas. Said first substance may be an organic solvent.

Said light beam may be a bundled or focussed light beam. The light beam is then moved around over the sample point per point. The size of the defects which can be seen depends on the size of the light beam used: the smaller the light beam used, the smaller the defects can be detected.

Said light beam may be a beam delivering visible light, UV light, IR radiation or X-rays.

In a method according to the present invention, said first threshold value may be determined by a method comprising:
providing said semiconductor substrate comprising said covering layer, said covering layer being at least partially exposed,
subjecting at least part of said covering layer to a second substance, without essentially exposing said covering layer to said first substance,
subjecting at least a part of said covering layer to a light beam,
detecting light scattered and rejecting light directly reflected by the covering layer, and
deriving the first threshold value from the detected scattered light.

The second substance may be air or another environmental substance.

The underlying layer may be made of a material having a low dielectric constant.

The covering layer may substantially cover said underlying layer. The covering layer may be a hardmask layer or a barrier layer.

In one embodiment, the covering layer may be deposited on the underlying layer. Alternatively, the covering layer may be a modification of the underlying layer such that at least a part of the underlying layer is a covering layer.

According to a further embodiment of the present invention, a method according to the present invention may be used for quality testing of the covering layer.

A method according to the present invention may further comprise accepting or rejecting the layer, and therefore accepting or rejecting the sample under inspection.

A method according to the present invention may further comprise changing parameters of a fabricating process for fabricating the covering layer.

The present invention further provides use of the method according to the present invention, in a process control unit, said process control unit being for controlling a fabrication process of covering layers.

The present invention also provides an apparatus for determining integrity of a covering layer on a semiconductor substrate said covering layer being at least partially exposed, the apparatus having
means for subjecting at least a part of said covering layer to a first substance,
illumination means for subjecting at least a part of said covering layer to a light beam,
detection means for detecting an amount of light scattered and rejection means for rejecting light directly reflected by the covering layer,
indicating means for indicating the integrity of said covering layer by determining if said amount of scattered light differs from a first threshold value, the amount of scattered light indicating a level of penetration of the first substance through the covering layer.

Said first substance may be a liquid, a vapour or a gas. Said first substance may be an organic solvent.

Said light beam may be a bundled or focussed light beam. Said light beam may be a beam delivering visible light, UV light, IR radiation or X-rays.

These and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a process sequence for the detection of defects in a covering layer according to an embodiment of the present invention.
Fig. 2 is a defect map after scanning of a wafer with oblique incident light beam, illustrating wafer defects before solvent absorption
Fig. 3 is a Haze map before (A) and after (B) toluene treatment of the wafer.
Fig. 4 are microscope pictures of a covering defect (A) and a normal defect (B), both on the same wafer after toluene treatment according to an embodiment of the present invention.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. Where the term "comprising" is used in the present description and claims, it does not exclude other elements or steps.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The present invention relates to a method and apparatus for determining the integrity or sealing efficiency of a covering layer on a substrate such as a semiconductor substrate. In embodiments of the present invention, the term "substrate" may include any underlying material or materials that may be used, or upon which a device, a circuit or an epitaxial layer may be formed. In other alternative embodiments, this "substrate" may include a semiconductor substrate such as e.g. a doped silicon, a gallium arsenide (GaAs), a gallium arsenide phosphide (GaAsP), a germanium (Ge), or a silicon germanium (SiGe) substrate. The "substrate" may include for example, an insulating layer such as a SiO₂ or an Si₃N₄ layer in addition to a semiconductor substrate portion. Thus, the term substrate also includes silicon-on-glass, silicon-on sapphire substrates. The term "substrate" is thus used to define generally the elements for layers that underlie a layer or portions of interest, especially a porous layer such as e.g. a low-k material layer. Also, the "substrate" may be any other base on which a layer is formed, for example a glass or metal layer. The semiconductor substrate may be for example a semiconductor substrate which is used in IC processing, but is not limited hereto.

In the following processing will mainly be described with reference to silicon processing because at present silicon is the conventional semiconductor material, but the skilled person will appreciate that the present invention may be implemented based on other semiconductor material systems and that the skilled person can select suitable materials as equivalents of the dielectric and conductive materials described below.

A covering layer is used for covering, for example for sealing, an underlying layer that is a substrate or has been deposited onto a substrate. With the method described in this invention, a covering defect in the surface of a material system can be determined by using an optical non-destructive method. The method may be applied during processing of the devices and is not limited to quantifying the integrity or sealing efficiency of a dielectric film exhibiting constitutive and/or subtractive porosity and/or voids or pores related to intentional or non-intentional pores in the material (such as killer voids), which are larger than the expected average pore size. The method, as described in the present invention, can also be used for testing the integrity of stacked wafers, which comprise a stack of layers, such as for example SOI wafers: Si/SiO₂/Si. In this way, defects in the upper Si layer due to e.g. HF cleaning of the Si or by deposition of said upper layer, can be detected. The Si layer is not considered as a sealing layer, since the underlying layer is not porous nor subject to swelling in case of contact with a solvent. Furthermore, the method described in this invention can be used to test the sealing efficiency of air gaps. Air gaps are dielectrics comprising 100% air. The method of the present invention can also be used for testing sealing properties of MEMS or packaging for example.

For example, a semiconductor substrate is covered with an underlying layer and a covering layer, further called the sample, by first depositing a porous layer in any conventional way onto the semiconductor substrate, followed by covering of the porous layer with a covering layer. The porous layer, i.e. the underlying layer may for example be, but is not limited to, a layer having dielectric properties (low-k organic (e.g. polymer) or inorganic material, air gap). The covering layer may be an inorganic layer, an organic layer (e.g. a polymer), a metallic layer or a surface layer that is obtained by surface treatment of the underlying layer. When the covering layer is used as a barrier or a hardmask, this layer has to protect the underlying layer efficiently. Therefore, defects should be avoided. The quality of the covering layer, or the sealing efficiency, can be determined by the presence or absence of defects, called covering defects, in the layer.

For process optimisation, a distinction can be made between different kinds of covering defects.

A first kind of covering defects are defects caused by particles, which are enclosed or embedded in the porous layer. This particles may come from the environment, previous process steps or treatment of the substrate. They can have a diameter of e.g. 100 nm, while the underlying layer is very thin and has a thickness of e.g. 50 nm.

A second kind of defects are defects coming from outliers in the pore structures of the porous layer, e.g. non uniform porous volume distribution, non uniform pore size distribution, non uniformity in the deposition of the low k material, or killer voids in a porous layer. Such large voids can cause incorrect or incomplete coverage by the covering layer.

Another kind of defects are defects caused by an improper or insufficient treatment or insufficient thickness of the covering layer. In case the deposited covering layers do not have a sufficient thickness the possibility arises that discontinuous covering layers or discontinuities in the covering layers are formed. This gives rise to layers with defects because the underlying layer is not fully covered by the covering layer and hence is exposed to several outside influences.

A fourth kind of defects relates to inhomogeneities in the sealing layer, such as e.g. defects in step coverage, asymmetric deposition of sealing layers, non-uniform deposition of sealing layers or sealing treatments.

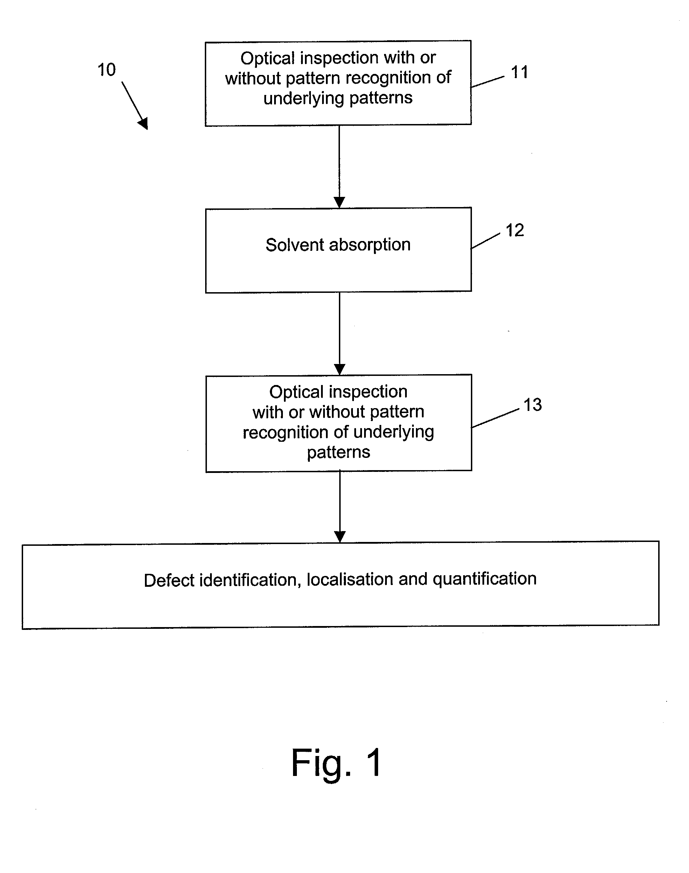

In Fig. 1 a process sequence 10 to be followed according to the present invention for detection of defects in covering layers is shown. According to the present invention, a sample is inspected before and after a solvent absorption step, in order to inspect differences in light absorption, light scattering and/or light reflection.

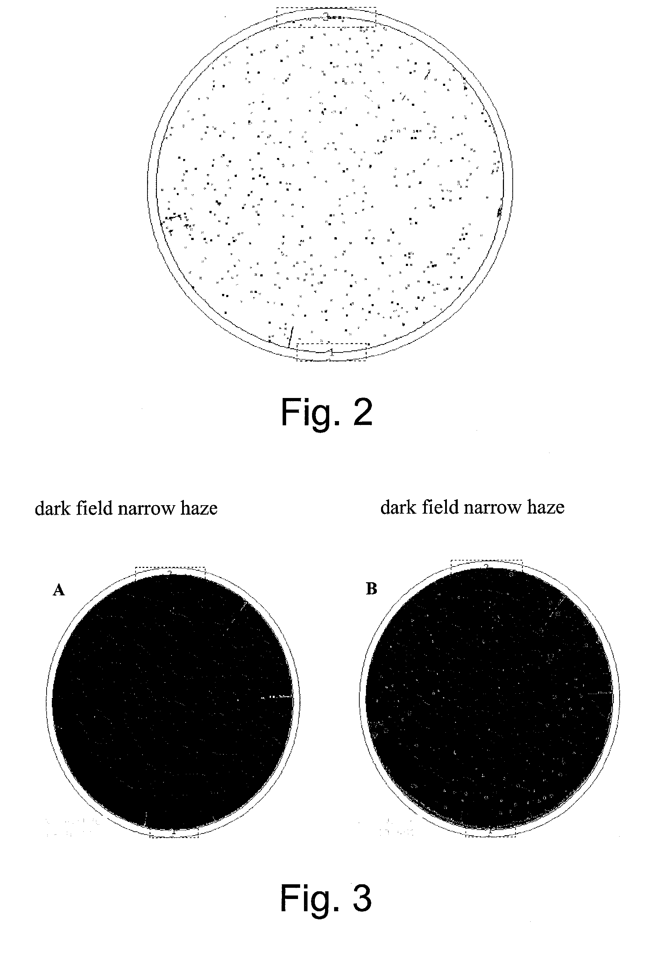

In a first measurement step 11, before solvent absorption, a sample is fully scanned, i.e. a scan of the complete wafer is performed, for any or all type of defects. This may be done with a normal light beam or with an oblique incident light beam in order to determine the number of particles present at the surface of the sample. The result of such measurement step 11 for a particular sample is shown in Fig. 2. In that way the sample surface is being mapped and localisation of the particles is carried out.

In a next step the sample is scanned in order to obtain a haze signal of the sample before solvent treatment. In principle, the determination of this haze signal should only be done once. This signal is then further being used as a reference.

The haze signal is the representation of the low frequency signal present in the total scattering signal, i.e. continuous background scattering. An example of a haze map before solvent treatment is shown in Fig. 3A.

Subsequently, the sample is subjected to solvent absorption from the side of the covering layer in step 12. Therefore the covering layer, which is on top of the sample is exposed to preferably a liquid, a vapour or a gas, for example a solvent. An appropriate choice of solvent needs to be made. The solvent has to be compatible with the material used as a covering layer, i.e. the solvent has to be inert towards the substrate and has to perform a good wetting of the covering layer. The solvent is preferably a highly volatile liquid. The vapour pressure of the liquid or vapour or gas should be high enough, such that no high vacuum is required. Typically, non-polar solvents as for example toluene, hexane, heptane are preferred, but other solvents as for example isopropyl alcohol, ethanol, water or any solvent that once absorbed into the porous film can lead to a change in optical properties of the material, may be used. Organic solvents such as alcohols are not dangerous to work with, do not damage the sample, are easily and cheaply available and have an acceptable vapour pressure, so that no high vacuum is needed. For example the vapour pressure of toluene at room temperature is 45 mm Hg. The molecule size of the solvent can be an important parameter. The kinetic diameter of the molecules in the solvent will affect the smallest covering defect that can be detected. For example, for toluene, the kinetic diameter is about 0.6 nm.

The solvent absorption step may be carried out by e.g. immersing the sample in a solvent solution or by bringing the sample in contact with a solvent vapour. The latter may be done by e.g. loading the sample into a vacuum chamber. For example, the chamber can be pumped down until the vacuum inside reaches 10⁻² to 10⁻³ Torr. The chamber may be then quickly filled with a solvent vapour. The capped or treated film surface is than exposed to solvent vapour at its saturation pressure at room temperature and for a time sufficient to allow solvent penetration into the porous film through the defects present at the surface. Typically, such time may be from a few seconds to one hour, but preferably between 1 to 15 minutes. After pumping out the solvent vapour remaining in the chamber, the wafer is immediately transferred to an optical inspection tool such that in a subsequent step defects may optically be localised and quantified.

If the covering layer is not perfect, absorption or adsorption of the solvent will take place. This is noticeable during an optical inspection step 13 after solvent absorption. Places where defects occur in the covering layer, and hence where the solvent is diffused into the covering layer, will show a change in optical properties. By inspection before (step 11) and after (step 13) the solvent absorption step 12, differences in coloration may be observed by the naked eye in case of long absorption times, typically between 0 and 15 min. For small defects, e.g. with sizes between 100 nm and 1 mm and preferably about 10 micron, differences in light scattering can be seen by using e.g. a KLA-Tencor SP1^{DLS} obtainable from KLA Tencor, One technology Drive, Milpitas, California, US. Such differences can be so that the light scattering exceeds a threshold value or is less than that threshold value, the threshold value corresponding to an amount of scattered light observable before the solvent absorption step. In the above apparatus a sample is scanned with a 488 nm laser-spot, but in principle all wavelengths can be used. Generally visible light will be used, but the invention is not limited thereto. The wavelengths used are limited by the materials to be inspected: the composition and thickness of the covering layer. The light beam used is thus a focussed or bundled light beam, which is locally applied and moved around with respect to the sample. The sizes of defects one can see depend on the size of the light beam used. Scattered light is captured by a detector and brought to a photo-multiplier, the directly reflected light is rejected. A difference in light scattering may be observed when a solvent is present in the underlying layer. With the method described above, the whole sample surface is scanned. In that way a map can be generated where the positions are linked to different scattering intensities. The detected covering defects can be correlated to the patterns on the chip/wafer, to the particles on the chip/wafer or to any other measurement done on the same wafer.

Some signal processing may be needed to identify, localise and quantify the defects from the collected scattered light. This signal processing lies within the reach of a person skilled in the art. A haze map after solvent treatment is shown in Fig. 3B. The defects that are causing leakage, i.e. the covering defects or covering defects, can be distinguished from other defects, localised and quantified by using the technique described above. The haze map may be obtained by filtering out the low frequency signal form the total signal. The total scattered light comprises a part coming from the haze signal and another part coming from defects. The haze signal is filtered out, typically with a low bandpass filter. A haze measurement is a standard test available on the above-mentioned KLA-Tencor SP1DLS device.

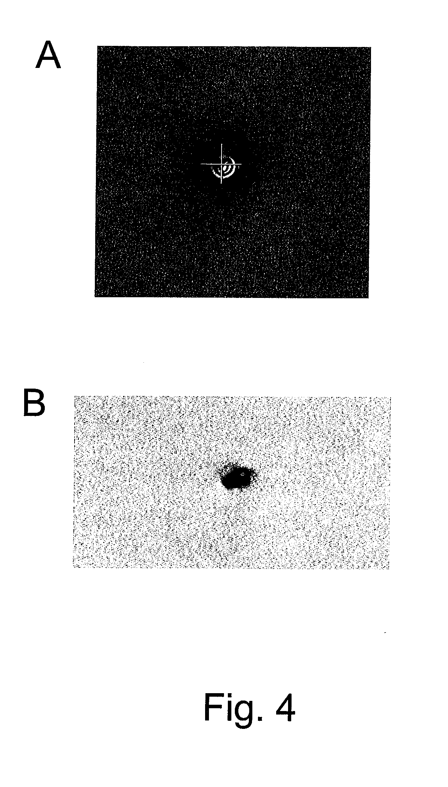

In Fig. 4 are shown pictures of a covering defect (Fig. 4A) and a normal defect (Fig. 4B) both on the same wafer after solvent treatment. The pictures are made with an optical microscope. The covering defect is surrounded by a halo, caused by solvent absorption.

With the method described in the first embodiment of the present invention it becomes possible to remove devices with defects from a process line at the manufacturing level. When solvent absorption occurs, the device has a bad covering layer and is not to be further processed, and is thus removed from the process flow. If on the other hand, no solvent absorption takes place, the device can be further processed because the covering layer is formed correctly and hence fully protects the underlying layer.

An example of the use of the method of the present invention is now described. In this example a p-type silicon wafer is used as a substrate. Onto the silicon wafer, which has e.g. a thickness of 200 nm, a low k material (LKD) is deposited which is then covered with e.g. 50 nm hardmask of e.g. SiC. To form the hardmask, various kinds of materials may be used, as known by a person skilled in the art. The hardmask may have a thickness below 200 nm. Preferably the hardmask thickness is as low as possible, such as 200 nm or less, preferably 100 nm or less. An ultimate goal is to make the hardmask so thin that it can be formed by a monolayer.

According to the process sequence of the present invention, as illustrated in Fig. 1, the wafer is first fully inspected for all type of defects with for example an oblique incident beam before solvent absorption to obtain a defect map as shown in Fig. 2. In another step, which may be simultaneous with the first step, the wafer is scanned in order to obtain the haze signal of the wafer, again before solvent absorption. Subsequently, the samples are brought into a solvent environment, e.g. a toluene ambient which is at the vapour pressure of toluene (45 mm Hg) for 5 minutes. After that, optical measurements are performed with the KLA-Tencor SP1^{DLS} over the full wafer to obtain a haze map after solvent treatment.

In a further embodiment some other combinations of covering layers/underlying layers have been researched with the method as described above, e.g. inorganic layers (e.g. LKD) / polymer layer (e.g. FF02); polymer layer (e.g. silk) / inorganic layer (e.g. SiC); and inorganic layer (e.g. zirkon) / metal layer (e.g. Ta). For all these, it is possible to determine the presence of defects in the covering layer.

It is to be understood that although preferred embodiments, specific constructions and configurations, as well as materials, have been discussed herein for devices according to the present invention, various changes or modifications in form and detail may be made without departing from the scope and spirit of this invention.

## Claims

1. A method for determining integrity of a covering layer on a semiconductor substrate, said method comprising:
providing the semiconductor substrate comprising the covering layer, said covering layer being at least partially exposed,
subjecting at least a part of said covering layer to a first substance,
subjecting at least a part of said covering layer to a light beam,
detecting an optical property of the covering layer,
indicating the integrity of said covering layer by determining if said optical property differs from a first threshold value, the optical property indicating a level of penetration of the first substance through the covering layer.

2. A method according to claim 1, wherein detecting an optical property comprises detecting an amount of light scattered and rejecting light directly reflected by the covering layer, and wherein indicating the integrity of said covering layer comprises determining if said amount of scattered light differs from a first threshold value, the amount of scattered light indicating a level of penetration of the first substance through the covering layer.

3. A method according to any of the previous claims, wherein said covering layer has holes and wherein said first substance is able to interact with said semiconductor substrate or an underlying layer between said semiconductor substrate and said covering layer.

4. A method according to any of the previous claims, wherein said first substance is a liquid, a vapour or a gas.

5. A method according to any of the previous claims, wherein said first substance is an organic solvent.

6. A method according to any of the previous claims, wherein said light beam is a bundled light beam.

7. A method according to any of the previous claims, wherein said light beam is a beam delivering visible light, UV light, IR radiation or X-rays.

8. A method according to any of the previous claims, wherein said first threshold value is determined by a method comprising:
providing said semiconductor substrate comprising said covering layer, said covering layer being at least partially exposed,
subjecting at least part of said covering layer to a second substance, without essentially exposing said covering layer to said first substance,
subjecting at least a part of said covering layer to a light beam,
detecting light scattered and rejecting light directly reflected by the covering layer, and
deriving the first threshold value from the detected scattered light.

9. A method according to claim 8, wherein said second substance is air or another environmental substance.

10. A method according to any of claims 3 to 9, wherein said underlying layer is made of a material having a low dielectric constant.

11. A method according to any of claims 3 to 10, wherein the covering layer substantially covers said underlying layer.

12. A method according to claim 11, wherein said covering layer is being deposited on the underlying layer.

13. A method according to any of the previous claims, wherein said method is used for quality testing of said covering layer.

14. A method according to any of the previous claims, further comprising accepting or rejecting the layer.

15. A method according to any of the previous claims, further comprising changing parameters of a fabricating process for fabricating the covering layer.

16. Use of the method according to any of the previous claims, in a process control unit, said process control unit being for controlling a fabrication process of covering layers.

17. Apparatus for determining integrity of a covering layer on a semiconductor substrate said covering layer being at least partially exposed, the apparatus having
means for subjecting at least a part of said covering layer to a first substance,
illumination means for subjecting at least a part of said covering layer to a light beam,
detection means for detecting an amount of light scattered and rejection means for rejecting light directly reflected by the covering layer,
indicating means for indicating the integrity of said covering layer by determining if said amount of scattered light differs from a first threshold value, the amount of scattered light indicating a level of penetration of the first substance through the covering layer.

18. Apparatus according to claim 17, wherein said first substance is a liquid, a vapour or a gas.

19. Apparatus according to any of claims 17 or 18, wherein said first substance is an organic solvent.

20. Apparatus according to any of claims 17 to 19, wherein said light beam is a bundled light beam.

21. Apparatus according to any of claims 17 to 20, wherein said light beam is a beam delivering visible light, UV light, IR radiation or X-rays.
